# EUROPEAN PATENT APPLICATION

(11) **EP 1 978 554 A2**
(43) Date of publication of application: **08.10.2008**
(21) Application number: 08004607.1
(22) Date of filing: 12.03.2008
(51) Int. Cl.: H01L 21/762, H01L 21/265, H01L 27/12, H01L 21/312, H01L 21/316, H01L 21/786, H01L 29/786

(54) **Method for manufacturing semiconductor substrate comprising implantation and separation steps**

(30) Priority: 06.04.2007 JP 2007101181; 19.04.2007 JP 2007109943
(71) Applicant: SEMICONDUCTOR ENERGY LABORATORY CO., LTD., Atsugi-shi, Kanagawa-ken 243-0036 (JP)
(72) Inventor: Shunpei, Yamazaki, Atsugi-shi Kanagawa-ken 243-0036 (JP)
(74) Representative: Grünecker, Kinkeldey, Stockmair & Schwanhäusser Anwaltssozietät

(57) **Abstract**

A method for manufacturing a semiconductor substrate is provided, which comprises a step of irradiating a single crystal semiconductor substrate with ions to form an embrittlement layer in the single crystal semiconductor substrate, a step of forming a silicon oxide film over the single crystal semiconductor substrate, a step of bonding the single crystal semiconductor substrate and a substrate having an insulating surface with the silicon oxide film interposed therebetween, a step of performing a thermal treatment, and a step of separating the single crystal semiconductor substrate with a single crystal semiconductor layer left over the substrate having the insulating surface.

## Description

### BACKGROUND OF THE INVENTION

### 1. Field of the Invention

The present invention relates to a method for manufacturing a semiconductor substrate. In particular, the present invention relates to a semiconductor substrate in which a single crystal semiconductor layer or a polycrystalline semiconductor layer is bonded to a substrate having an insulating surface such as glass, and a semiconductor device.

### 2. Description of the Related Art

Integrated circuits have been developed, which use a semiconductor substrate called a silicon-on-insulator (SOI) substrate that has a thin single crystal semiconductor layer over an insulating surface, instead of a silicon wafer that is manufactured by thinly slicing an ingot of a single crystal semiconductor. An integrated circuit using an SOI substrate has been attracting attention because parasitic capacitance between drains of the transistors and the substrate is reduced and a semiconductor integrated circuit is made to have higher performance.

As a method for manufacturing SOI substrates, a hydrogen ion implantation separation method is known (for example, see Reference 1: United States Patent No. 6372609). The hydrogen ion implantation separation method is a method in which a silicon wafer is irradiated with hydrogen ions to form a microbubble layer in the silicon wafer at a predetermined depth from a surface thereof, the microbubble layer is used as a cleavage plane, and a thin silicon layer (SOI layer) is bonded to another silicon wafer. In addition to thermal treatment for separation of an SOI layer, it is necessary to perform thermal treatment in an oxidizing atmosphere to form an oxide film on the SOI layer, remove the oxide film, and perform thermal treatment at 1000 to 1300°C in a reducing atmosphere to increase bond strength.

One of the known examples of semiconductor devices using SOI substrates is disclosed by the present applicant (see Reference 2: Japanese Published Patent Application No. 2000-12864). It is disclosed that thermal treatment at 1050 to 1150°C is necessary also in that case in order to eliminate levels and defects that are caused by stress in an SOI layer.

One of the known examples of SOI substrates in which SOI layers are formed over glass substrates, a structure is known in which a thin film of single crystal silicon having a covering film is formed over a glass substrate having a coating film by a hydrogen ion implantation separation method (see Reference 3: Japanese Published Patent Application No. 2004-134675). Also in this case, a piece of single crystal silicon is irradiated with hydrogen ions to form a microbubble layer in the piece of single crystal silicon at a predetermined depth from a surface thereof, a glass substrate is bonded to the piece of single crystal silicon, then, the piece of silicon is separated using the microbubble layer as a cleavage plane, and a thin silicon layer (SOI layer) is formed over the glass substrate.

### SUMMARY OF THE INVENTION

As described above, in a hydrogen ion implantation separation method, separation is performed using a layer of hydrogen ions with which a silicon wafer at a predetermined depth from a surface thereof is irradiated (embrittlement layer), as a cleavage plane, whereby a thin silicon layer is formed. Therefore, the thickness of the silicon layer depends on the depth of ion irradiation, and thus, it is difficult to obtain a silicon layer with a desired thickness if the depths of ion irradiation vary. It is to be noted that in the present invention, a region which is embrittled so as to include minute voids by the action of ions by irradiation of a single crystal semiconductor substrate with ions is referred to as an embrittlement layer.

In view of the foregoing problems, it is an object of the present invention to obtain an SOI substrate having a silicon layer with a desired thickness by control of the depth of an embrittlement layer.

It is another object of the present invention to provide a semiconductor substrate provided with a single crystal semiconductor layer in which bond strength of an SOI layer is high also in the case where a substrate with a low upper temperature limit such as a glass substrate is used for formation of an SOI substrate.

In order to solve the above-described problems, according to one aspect of the present invention, a single crystal semiconductor substrate is irradiated with one kind of ions having equal mass selected from inert gas ions, halogen ions, or H₃⁺ ions, so that an embrittlement layer is formed in a region of the single crystal semiconductor substrate at a predetermined depth from a surface of the single crystal semiconductor substrate.

In bonding a single crystal semiconductor layer to a substrate having an insulating surface or an insulating substrate, a silicon oxide film is formed preferably using organic silane as a material over one or both surfaces that are to form a bond. Examples of organic silane that can be used include silicon-containing compounds, such as tetraethoxysilane (TEOS) (chemical formula: Si(OC₂H₅)₄), trimethylsilane (TMS) (chemical formula: (CH₃)₃SiH), tetramethylcyclotetrasiloxane (TMCTS), octamethylcyclotetrasiloxane (OMCTS), hexamethyldisilazane (HMDS), triethoxysilane (chemical formula: SiH(OC₂H₅)₃), and trisdimethylaminosilane (chemical formula: SiH(N(CH₃)₂)₃)- In other words, in a structure in which a single crystal semiconductor is bonded to a substrate having an insulating surface or an insulating substrate at low temperature (LTSS: a low temperature single crystal semiconductor), a layer whose surface is smooth and hydrophilic is provided as a bonding surface.

A single crystal semiconductor layer bonded to a substrate having an insulating surface or an insulating substrate is obtained by cleavage and separation in an embrittlement layer formed in a single crystal semiconductor substrate. The embrittlement layer is formed by irradiation with ions of hydrogen, helium, or halogen typified by fluorine which have equal mass.

A barrier layer is preferably provided over a substrate having an insulating surface or an insulating substrate to which an SOI layer is bonded. Owing to the barrier layer, the single crystal semiconductor layer can be prevented from being contaminated.

By irradiation of a single crystal semiconductor substrate with one kind of ions selected from inert gas ions, halogen ions, or H₃⁺ ions, variation of depths of ion irradiation is reduced, and an SOI substrate having a silicon layer with a desired thickness can be obtained.

When a single crystal semiconductor layer that is separated from a single crystal semiconductor substrate is bonded to a substrate serving as a base, the bond can be formed at a temperature of 700°C or lower by the use of a silicon oxide film having a hydrophilic surface and high planarity, and including hydrogen. According to this structure, even when a substrate with an upper temperature limit of 700°C or lower, such as a glass substrate, is used, a single crystal semiconductor layer provided with a bonding portion with high bond strength can be obtained.

As a substrate to which a single crystal semiconductor layer is fixed, it is possible to use any of a variety of glass substrates that are used in the electronics industry and that are referred to as non-alkali glass substrates, such as aluminosilicate glass substrates, aluminoborosilicate glass substrates, and barium borosilicate glass substrates. In other words, a single crystal semiconductor layer can be formed over a substrate that is longer than one meter on each side. With the use of such a large-area substrate, not only a display device such as a liquid crystal display but also a semiconductor integrated circuit can be manufactured.

### BRIEF DESCRIPTION OF THE DRAWINGS

In the accompanying drawings:
FIGS. 1A and 1B are cross-sectional views each showing a structure of a semiconductor substrate;
FIGS. 2A and 2B are cross-sectional views each showing a structure of a semiconductor substrate;
FIGS. 3A to 3C are cross-sectional views illustrating a manufacturing method of a semiconductor substrate;
FIG 4 is a cross-sectional view illustrating a manufacturing method of a semiconductor substrate;
FIG 5A to 5C are cross-sectional views illustrating a manufacturing method of a semiconductor substrate;
FIGS. 6A to 6D are cross-sectional views illustrating a manufacturing method of a semiconductor device using a semiconductor substrate;
FIG 7 is a cross-sectional view illustrating a manufacturing method of a semiconductor device using a semiconductor substrate;
FIG 8 is a block diagram showing a structure of a microprocessor that is obtained using a semiconductor substrate;
FIG. 9 is a block diagram showing a structure of an RFCPU that is obtained using a semiconductor substrate;
FIG 10 is a plan view exemplifying the case where a single crystal semiconductor layer is bonded to mother glass which is used for manufacturing a display panel; and
FIGS. 11A and 11B are views showing an example of a display panel in which a pixel transistor is formed using a single crystal semiconductor layer.

### DETAILED DESCRIPTION OF THE INVENTION

### (Embodiment Mode)

### (Embodiment Mode 1)

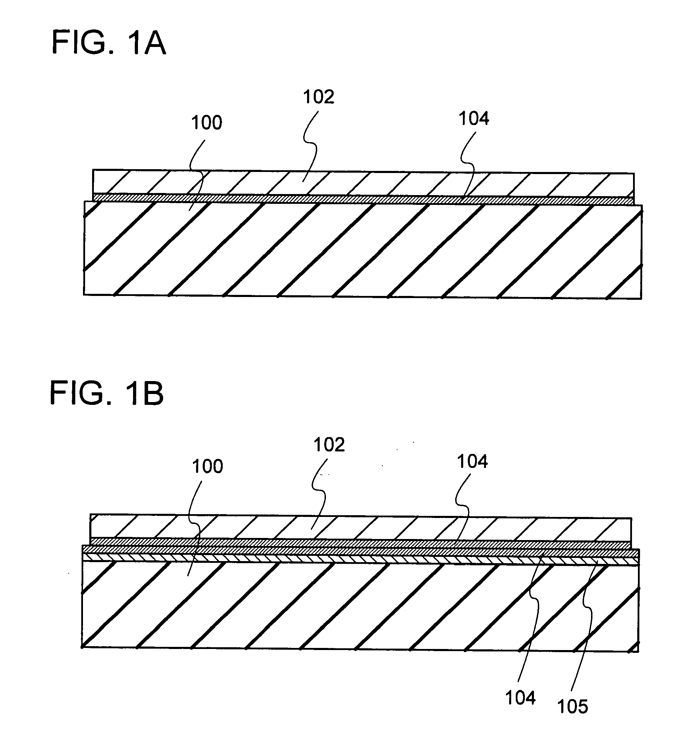

Each of FIGS. 1A and 1B shows a semiconductor substrate formed according to the present invention. In FIG 1A, a base substrate 100 is a substrate having an insulating surface or an insulating substrate, and any of a variety of glass substrates that are used in the electronics industry, such as aluminosilicate glass substrates, aluminoborosilicate glass substrates, and barium borosilicate glass substrates, can be used. Alternatively, a quartz glass substrate or a semiconductor substrate such as a silicon wafer can be used. A single crystal semiconductor layer 102 is formed from a single crystal semiconductor, and single crystal silicon is typically used. Alternatively, a crystalline semiconductor layer formed from silicon, germanium, or a compound semiconductor such as gallium arsenide or indium phosphide which can be separated from a single crystal semiconductor substrate or a polycrystalline semiconductor substrate by a hydrogen ion implantation separation method, for example, can be used.

Between the base substrate 100 and the single crystal semiconductor layer 102 which are described above, a bonding layer 104 whose surface is smooth and hydrophilic is provided. A silicon oxide film is suitable for use as the bonding layer 104. In particular, a silicon oxide film formed by a chemical vapor deposition method using an organic silane gas is preferable. Examples of organic silane that can be used include silicon-containing compounds such as tetraethoxysilane (TEOS) (chemical formula: Si(OC₂H₅)₄), trimethylsilane (TMS) (chemical formula: (CH₃)₃SiH), tetramethylcyclotetrasiloxane (TMCTS), octamethylcyclotetrasiloxane (OMCTS), hexamethyldisilazane (HMDS), triethoxysilane (chemical formula: SiH(OC₂H₅)₃), and trisdimethylaminosilane (chemical formula: SiH(N(CH₃)₂)₃).

The bonding layer 104 whose surface is smooth and hydrophilic is provided to a thickness of 5 to 500 nm. With such a thickness, it is possible to smooth surface roughness of a surface on which a film is to be formed and also to ensure smoothness of a growing surface of the film. In addition, distortion of the substrate and the single crystal semiconductor layer that are to be bonded together can be relieved. The base substrate 100 may also similarly be provided with a silicon oxide film. In other words, in bonding the single crystal semiconductor layer 102 to the base substrate 100 that is a substrate having an insulating surface or an insulating substrate, a strong bond can be formed when the bonding layer 104 formed of a silicon oxide film preferably using organic silane as a material is provided over one or both of surfaces that are to form a bond.

The bonding layer 104 is provided over the single crystal semiconductor layer 102 side and is disposed in contact with a surface of the base substrate 101, whereby bonding can be performed even at room temperature. In order to form a stronger bond, the base substrate 100 and the single crystal semiconductor layer 102 may be pressed. Further, thermal treatment is preferably performed. The thermal treatment may be performed under pressure.

To bond the base substrate 100 and the bonding layer 104, which are formed from different kinds of materials, to each other at low temperature, surfaces thereof are cleaned. When the base substrate 100 and the bonding layer 104 are disposed in contact with each other in such a condition, a bond is formed by attraction between the surfaces. It is preferable to perform treatment in which a plurality of hydroxy groups is attached to at least one of surfaces of the base substrate 100 and the bonding layer 104. For example, it is preferable to perform oxygen plasma treatment or ozone treatment on a surface of the base substrate 100 so that the surface is made hydrophilic. In the case of performing treatment in which the surface of the base substrate 100 is made hydrophilic, a bond is formed by hydrogen bonding by the action of a hydroxy group on the surface. To increase strength of a bond formed at room temperature, it is preferable to perform thermal treatment.

As treatment for bonding the base substrate 100 and the bonding layer 104, which are formed from different kinds of materials, to each other at low temperature, a surface that is to form a bond is formed may be cleaned by being irradiated with an ion beam using an inert gas such as argon. By the irradiation with an ion beam, a dangling bond is exposed on at least one of surfaces of the base substrate 100 and the bonding layer 104 and an extremely active surface is formed. When surfaces of the base substrate 100 and the bonding layer 104, at least one of which is an active surface, are disposed in contact with each other, a bond can be formed even at low temperature. A method for forming a bond by activation of a surface is preferably carried out in vacuum because the surfaces are needed to be highly cleaned.

The single crystal semiconductor layer 102 is formed by separating a thin slice from a single crystal semiconductor substrate. For example, the single crystal semiconductor layer 102 can be formed by an ion implantation separation method in which a single crystal semiconductor substrate at a predetermined depth is irradiated with H₃⁺ ions, ions of halogen such as fluorine, or ions of inert gas which have equal mass, and then, thermal treatment is performed and thus a single crystal silicon layer in an outer layer is separated. Alternatively, a method may be used in which after single crystal silicon is epitaxially grown over porous silicon, cleavage by water-jetting is performed so that a porous silicon layer is separated. A thickness of the single crystal semiconductor layer 102 is set to be 5 to 500 nm, preferably 10 to 200 nm.

FIG 1B shows a structure in which the base substrate 100 is provided with a barrier layer 105 and the bonding layer 104. When the single crystal semiconductor layer 102 is bonded to the base substrate 100, the single crystal semiconductor layer 102 can be prevented from being contaminated by impurities such as mobile ions like alkali metal or alkaline earth metal that are diffused from a glass substrate that is used as the base substrate 100. The bonding layer 104 on the base substrate 100 side may be provided as appropriate.

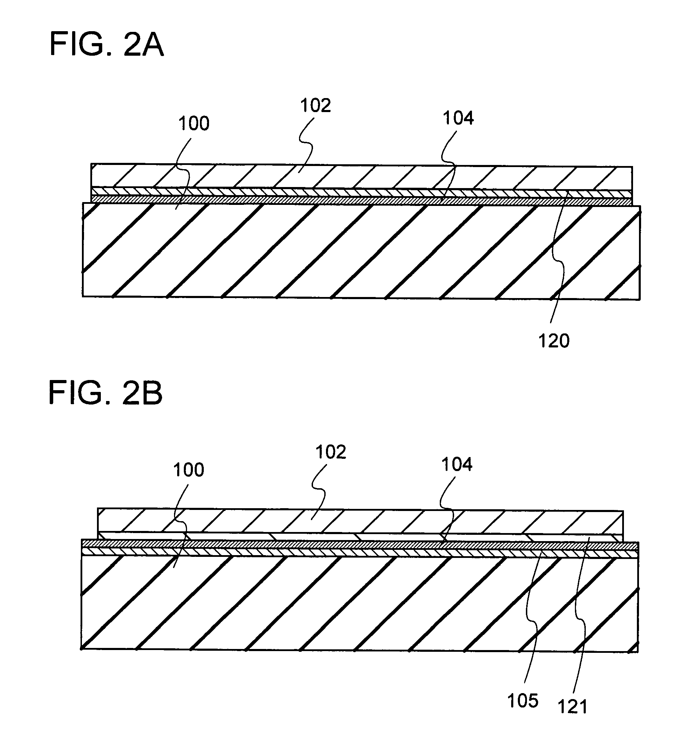

FIG. 2A shows a structure in which a nitrogen-containing insulating layer 120 is provided between the single crystal semiconductor layer 102 and the bonding layer 104. The nitrogen-containing insulating layer 120 is formed using a single layer or a stacked layer of a plurality of films selected from a silicon nitride film, a silicon nitride oxide film, or a silicon oxynitride film. For example, the nitrogen-containing insulating layer 120 can be formed by stacking a silicon oxynitride film and a silicon nitride oxide film in this order from the single crystal semiconductor layer 102 side. It is to be noted that the nitrogen-containing insulating layer 120 is formed over a surface of a single crystal semiconductor substrate that is to be the single crystal semiconductor layer 102 before ion irradiation is performed. The bonding layer 104 is provided in order to form a bond with the base substrate 100 whereas the nitrogen-containing insulating layer 120 is preferably provided in order to prevent impurities such as mobile ions or moisture from diffusing into and contaminating the single crystal semiconductor layer 102.

Note that a silicon oxynitride film means a film that contains more oxygen than nitrogen and, in the case where measurements are performed using Rutherford backscattering spectrometry (RBS) and hydrogen forward scattering (HFS), includes oxygen, nitrogen, silicon, and hydrogen at concentrations ranging from 50 at.% to 70 at.%, 0.5 at.% to 15 at.%, 25 at.% to 35 at.%, and 0.1 at.% to 10 at.%, respectively. Further, a silicon nitride oxide film means a film that contains more nitrogen than oxygen and, in the case where measurements are performed using RBS and HFS, includes oxygen, nitrogen, silicon, and hydrogen at concentrations ranging from 5 at.% to 30 at.%, 20 at.% to 55 at.%, 25 at.% to 35 at.%, and 10 at.% to 30 at.%, respectively. Note that percentages of nitrogen, oxygen, silicon, and hydrogen fall within the ranges given above, where the total number of atoms contained in the silicon oxynitride film or the silicon nitride oxide film is defined as 100 at.%.

FIG 2B shows a structure in which the base substrate 100 is provided with the bonding layer 104. The barrier layer 105 is preferably provided between the base substrate 100 and the bonding layer 104. The barrier layer 105 is provided in order to prevent the single crystal semiconductor layer 102 from being contaminated by impurities such as mobile ions like alkali metal or alkaline earth metal that are diffused from a glass substrate that is used as the base substrate 100. In addition, the single crystal semiconductor layer 102 is provided with a silicon oxide film 121. This silicon oxide film 121 forms a bond with the bonding layer 104 to fix the single crystal semiconductor layer over the base substrate 100. The silicon oxide film 121 is preferably formed by thermal oxidation.

### (Embodiment Mode 2)

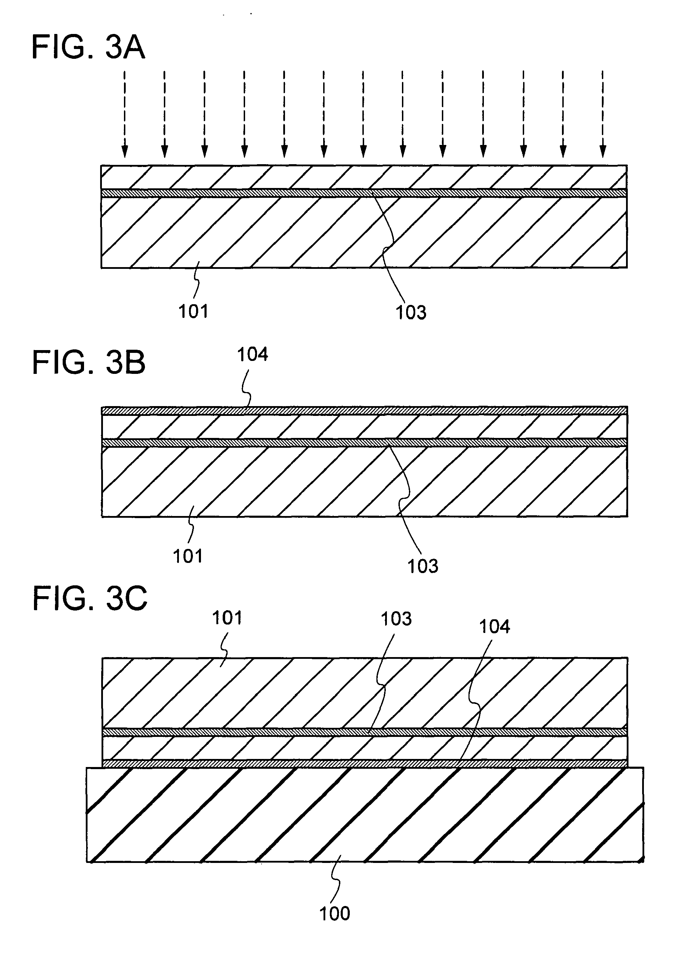

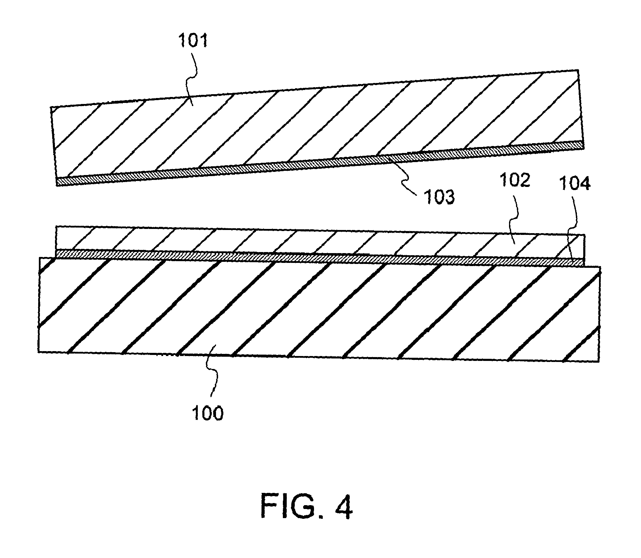

This embodiment mode describes a method for manufacturing a semiconductor substrate described in Embodiment Mode 1 with reference to FIGS. 3A to 3C and FIG. 4.

A semiconductor substrate 101 shown in FIG. 3A is cleaned, and the semiconductor substrate 101 is irradiated with ions having equal mass that are accelerated by an electric field from a surface thereof to form an embrittlement layer 103 in the semiconductor substrate 101 at a predetermined depth. In this embodiment mode, ions of a halogen atom (also referred to as halogen ions) which had been subjected to mass separation are used. The halogen ions which had been subjected to mass separation are obtained by subjecting the material (mainly gas) including a halogen atom to mass separation. The ion irradiation is carried out in consideration of the thickness of a single crystal semiconductor layer that is to be transferred to the base substrate. A thickness of the single crystal semiconductor layer is set to be 5 to 500 nm, preferably 10 to 200 nm. An accelerating voltage in irradiating the semiconductor substrate 101 with ions is set in consideration of such a thickness. The embrittlement layer is formed by irradiation with ions of halogen typified by fluorine, which had been subjected to mass separation to have equal mass. In the case of irradiation with ions of fluorine as a halogen element, BF₃ may be used as a source gas.

In the case where the single crystal silicon substrate is irradiated with halogen ions such as fluorine ions by an ion implantation method, fluorine with which the single crystal silicon substrate is irradiated knocks out (expels) a silicon atom in a crystal lattice of silicon, whereby a vacant portion is effectively generated and thus minute voids are produced in the embrittlement layer. In this case, the volume of the minute voids formed in the embrittlement layer is changed by thermal treatment at comparatively low temperature, and a thin single crystal semiconductor layer like the one described above can be formed by cleavage along the embrittlement layer. After irradiation with fluorine ions which had been mass separation, irradiation with hydrogen ions which had been subjected to mass separation (H₃⁺ ions) may be performed so that hydrogen may be included in the voids. It is preferable to effectively utilize the action of halogen ions and hydrogen ions in such a manner because cleavage is performed along the embrittlement layer which is formed to separate a thin semiconductor layer from the semiconductor substrate by utilization of a change in the volume of the minute voids formed in the embrittlement layer.

Because there is need for irradiation with ions which had been subjected to mass separation in a condition at a high dose in forming the embrittlement layer, there are cases where the surface of the semiconductor substrate 101 is roughened. Therefore, a protective film against ion irradiation, such as a silicon nitride film or a silicon nitride oxide film, may be provided to a thickness of 50 to 200 nm over a surface irradiated with ions which are subjected to mass separation.

Next, as shown in FIG. 3B, a silicon oxide film is formed as a bonding layer 104 over a surface that is to form a bond with the base substrate. The silicon oxide film is preferably formed by a chemical vapor deposition method using an organic silane gas as described above. Alternatively, a silicon oxide film formed by a chemical vapor deposition method using a silane gas can be used. Film formation by a chemical vapor deposition method is performed at a formation temperature of, for example, 350°C or lower, as a temperature at which an atom included in the embrittlement layer 103 does not leave from the embrittlement layer 103 that is formed in the single crystal semiconductor substrate. It is to be noted that the atom included in the embrittlement layer 103 is the atom of the ions with which the semiconductor substrate 101 is irradiated to form the embrittlement layer 103. For example, in this embodiment mode, the atom included in the embrittlement layer 103 is a halogen atom since the halogen ions with which the semiconductor substrate 101 is irradiated to form the embrittlement layer 103. Further, thermal treatment for separation of the single crystal semiconductor layer from a single crystal semiconductor substrate or a polycrystalline semiconductor substrate is performed at higher temperature than a temperature at which the silicon oxide film is formed.

FIG. 3C shows a mode in which a base substrate 100 is disposed in contact with the bonding layer 104 formed over the semiconductor substrate 101, to bond the two to each other. A surface that is to form a bond is cleaned sufficiently. By disposing the base substrate 100 in contact with the bonding layer 104, a bond is formed therebetween. This bond is subjected to Van der Waals forces. By pressing the base substrate 100 and the semiconductor substrate 101 against each other, a stronger bond can be formed by hydrogen bonding.

In order to form a favorable bond, the surface may be activated. For example, the surface that is to form a bond is irradiated with an atomic beam or an ion beam. When an atomic beam or an ion beam is used, an inert gas neutral atom beam or inert gas ion beam of argon or the like can be used. Alternatively, plasma irradiation or radical treatment is performed. Such a surface treatment makes it easier to form a bond between different kinds of materials even at temperatures of 200 to 400°C.

After the base substrate 100 and the semiconductor substrate 101 are bonded to each other with the bonding layer 104 interposed therebetween, it is preferable that heat treatment or pressure treatment be performed. Heat treatment or pressure treatment makes it possible to increase bond strength. The heat treatment is preferably performed at a temperature lower than the upper temperature limit of the base substrate 100. The pressure treatment is performed so that pressure is applied in a direction perpendicular to the bonding surface, in consideration of the pressure resistance of the base substrate 100 and the semiconductor substrate 101.

In FIG. 4, after the base substrate 100 and the semiconductor substrate 101 are bonded together, thermal treatment is performed to separate the semiconductor substrate 101 from the base substrate 100 with the embrittlement layer 103 used as a cleavage plane. The thermal treatment is performed at temperature that the atom included in the embrittlement layer 103 leaves. It is to be noted that the atom included in the embrittlement layer 103 is the atom of the ions with which the semiconductor substrate 101 is irradiated to form the embrittlement layer 103. Also, the thermal treatment is preferably performed at a temperature ranging from the temperature at which the bonding layer 104 is formed to the upper temperature limit of the base substrate 100. When the thermal treatment is performed at, for example, 400 to 600°C, a change occurs in the volume of minute voids formed in the embrittlement layer 103, which enables cleavage to occur along the embrittlement layer 103. Because the bonding layer 104 is bonded to the base substrate 100, the single crystal semiconductor layer 102 having the same crystallinity as the semiconductor substrate 101 is left over the base substrate 100.

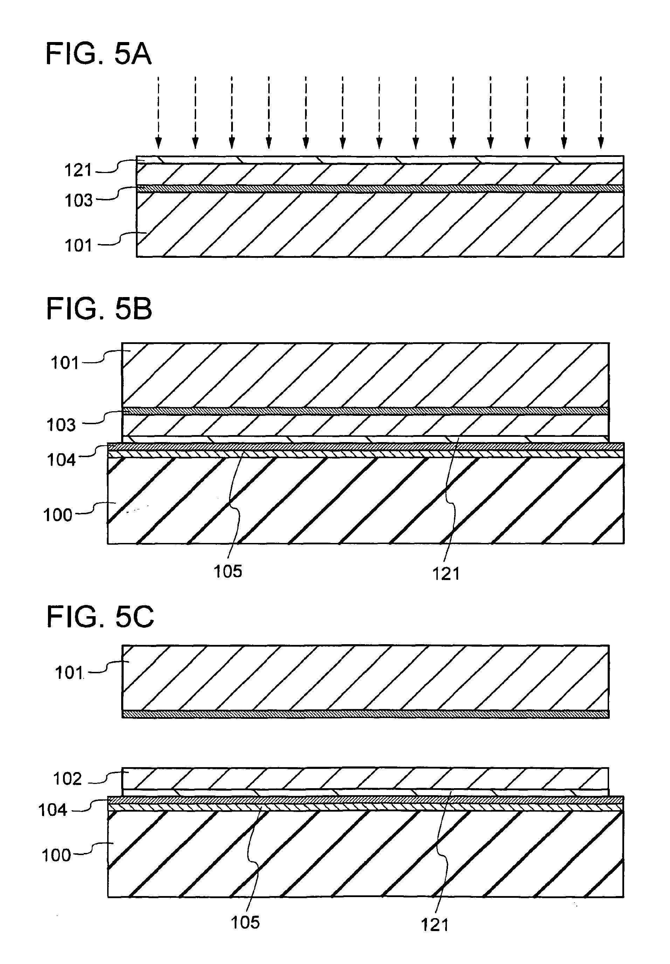

FIGS. 5A to 5C show steps of forming a single crystal semiconductor layer with a bonding layer provided over the base substrate side. FIG. 5A shows a step in which a semiconductor substrate 101 provided with a silicon oxide film 121 is irradiated with ions having equal mass that are accelerated by an electric field to form the embrittlement layer 103 in the semiconductor substrate 101 at a predetermined depth. The irradiation with ions of halogen typified by fluorine is similar to the case shown in FIG 3A. By formation of the silicon oxide film 121 over a surface of the semiconductor substrate 101, the surface can be prevented from being damaged by ion irradiation and from losing its planarity.

FIG 5B shows a step in which the base substrate 100 provided with a barrier layer 105 and the bonding layer 104 is disposed in contact with a surface of the silicon oxide film 121 formed over the semiconductor substrate 101 to form a bond. The bond is formed by disposing the bonding layer 104 over the base substrate 100 in contact with the silicon oxide film 121 formed over the semiconductor substrate 101.

After that, the semiconductor substrate 101 is separated as shown in FIG 5C. Thermal treatment for separation of the semiconductor substrate 101 is performed similarly to the case shown in FIG 4. In such a manner, the semiconductor substrate shown in FIG 2B can be obtained.

In this manner, according to this embodiment mode, the single crystal semiconductor layer 102 provided with a bonding portion with high bond strength can be obtained even when the base substrate 100 with an upper temperature limit of 700°C or lower, such as a glass substrate, is used. As the base substrate 100, it is possible to use any of a variety of glass substrates that are used in the electronics industry and that are referred to as non-alkali glass substrates, such as aluminosilicate glass substrates, aluminoborosilicate glass substrates, and barium borosilicate glass substrates. In other words, a single crystal semiconductor layer can be formed over a substrate that is longer than one meter on each side. With the use of such a large-area substrate, not only a display device such as a liquid crystal display but also a semiconductor integrated circuit can be manufactured.

Further, according to this embodiment mode, the embrittlement layer can be formed by irradiation with halogen ions; therefore, a thin single crystal semiconductor layer can be formed by thermal treatment at comparatively low temperature.

### (Embodiment Mode 3)

This embodiment mode describes another mode of a method for manufacturing a semiconductor substrate which is described in Embodiment Mode 2.

In this embodiment mode, a semiconductor substrate 101 is irradiated with inert gas ions that are accelerated by an electric field instead of the halogen ions in Embodiment Mode 2, from a surface of the semiconductor substrate 101 as shown in FIG 3A to form an embrittlement layer 103 in the semiconductor substrate 101 at a predetermined depth. It is to be noted that the inert gas ions are obtained by using a gas including an inert atom, and are referred to as inert ions or inert atom ions. The ion irradiation is carried out in consideration of the thickness of an LTSS layer that is to be transferred to a base substrate. A thickness of the LTSS layer is set to be 5 to 500 nm, preferably 10 to 200 nm. An accelerating voltage in irradiating the semiconductor substrate 101 with inert gas ions is set in consideration of such a thickness.

When inert gas ions (He, Ne, Ar, Kr, Xe, or the like) are used as ion species to form the embrittlement layer 103, ion species having equal mass are obtained even without mass separation. Accordingly, an SOI substrate having a silicon layer with a desired thickness, in which variation of depths of ion irradiation is small, can be obtained.

In forming the embrittlement layer 103, after irradiation of the semiconductor substrate 101 with inert gas ions (He, Ne, Ar, Kr, Xe, or the like), irradiation with hydrogen ions which had been subjected to mass separation, such as H₃⁺ ions, may further be performed. In that case, minute voids can be effectively produced in the embrittlement layer by irradiation with inert gas ions, and then, irradiation with hydrogen ions which had been subjected to mass separation (H₃⁺ ions) is performed, whereby hydrogen may be included in the voids. It is preferable to effectively utilize the action of inert gas ions and hydrogen ions in such a manner because cleavage is performed along the embrittlement layer which is formed to separate a thin semiconductor layer from the semiconductor substrate by utilization of a change in the volume of the minute voids formed in the embrittlement layer.

Other steps are similar to the steps shown in FIGS. 3A to 5C of Embodiment Mode 1.

### (Embodiment Mode 4)

This embodiment mode describes another mode of a method for manufacturing a semiconductor substrate which is described in Embodiment Mode 2 or 3.

In this embodiment mode, unlike that described in Embodiment Modes 2 and 3, a semiconductor substrate 101 at a predetermined depth from a surface thereof is irradiated with H₃⁺ ions, which had been subjected to mass separation and are accelerated by an electric field, as shown in FIG. 3A to form an embrittlement layer 103. The H₃⁺ ions which had been subjected to mass separation are obtained by subjecting the material (mainly gas) including a hydrogen atom to mass separation. The ion irradiation is carried out in consideration of the thickness of an LTSS layer that is to be transferred to a base substrate. A thickness of the LTSS layer is set to be 5 to 500 nm, preferably 10 to 200 nm. An accelerating voltage in irradiating the semiconductor substrate 101 with H₃⁺ ions which had been subjected to mass separation is set in consideration of such a thickness.

When hydrogen ions are subjected to mass separation and irradiation with only H₃⁺ ions is performed, variation of depths of ion irradiation is reduced compared to irradiation of hydrogen ions including H⁺, H₂⁺, and H₃⁺. Further, since a mass of an H₃⁺ ion is higher than that of any of an H⁺ ion and an H₂⁺ ion, efficiency in forming the embrittlement layer 103 can be enhanced.

Other steps are similar to the steps shown in FIGS. 3A to 5C of Embodiment Mode 1.

### (Embodiment Mode 5)

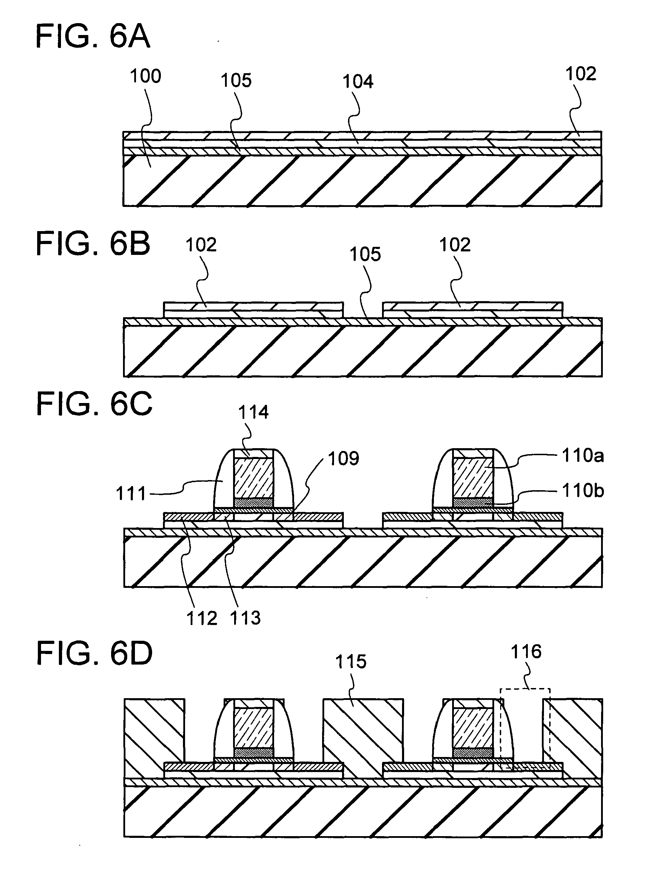

This embodiment mode describes a semiconductor device using the semiconductor substrate described in any of Embodiment Modes 1 and 2, with reference to FIGS. 6A to 11B.

FIG 6A shows a semiconductor substrate manufactured by a method described in any of Embodiment Modes 2 to 4. The semiconductor substrate has the base substrate 100 provided with the single crystal semiconductor layer 102 with the bonding layer 104 interposed therebetween. A thickness of the single crystal semiconductor layer 102 ranges from 5 to 500 nm, preferably 10 to 200 nm. The thickness of the single crystal semiconductor layer 102 can be set as appropriate by control of the depth of the embrittlement layer 103 that is shown in FIGS. 3A to 3C. To the single crystal semiconductor layer 102, a p-type impurity such as boron, aluminum, or gallium is added in order to control threshold voltage. For example, boron may be added as a p-type impurity at a concentration of greater than or equal to 5 x 10¹⁷ cm⁻³ and less than or equal to 1 x 10¹⁸ cm⁻³. Over the base substrate 100, a stack of a silicon nitride layer and a silicon oxide layer is formed as the barrier layer 105. By provision of the barrier layer over the base substrate 100, the single crystal semiconductor layer 102 can be prevented from being contaminated. It is to be noted that instead of the silicon nitride layer, a silicon nitride oxide layer, an aluminum nitride layer, or an aluminum nitride oxide layer may be used.

In FIG 6B, the single crystal semiconductor layer 102 is etched to form single crystal semiconductor layers 102 which are separated into island shapes to match arrangement of semiconductor elements.

In FIG. 6C, after the single crystal semiconductor layer 102 is exposed, a gate insulating layer 109, gate electrodes 110a and 110b, and a sidewall insulating layer 111 are formed, and a first impurity region 112 and a second impurity region 113 are formed. An insulating layer 114 is formed from silicon nitride and used as a hard mask when the gate electrodes 110a and 110b are etched.

In FIG. 6D, an interlayer insulating layer 115 is formed. As the interlayer insulating layer 115, a borophosphosilicate glass (BPSG) film is formed or an organic resin typified by polyimide is applied. A contact hole 116 is formed in the interlayer insulating layer 115. The contact hole 116 is formed into a self-aligned contact structure using the sidewall insulating layer 111.

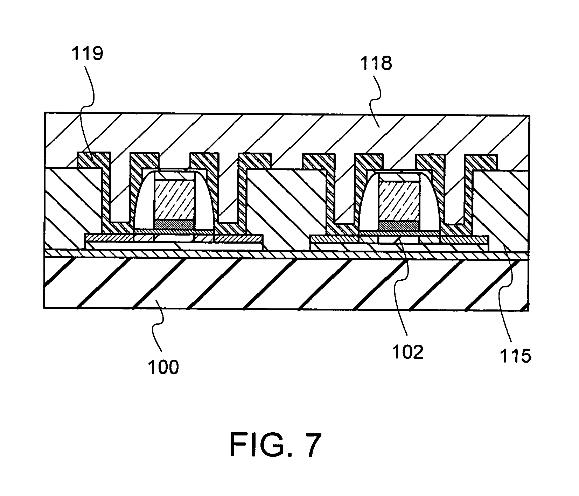

After that, as shown in FIG 7, a wiring 119 is formed to match the contact hole 116. The wiring 119 is formed from aluminum or an aluminum alloy and is provided with upper and lower metal films of molybdenum, chromium, titanium, or the like as barrier metal films. After that, an insulating layer 118 is formed over the wiring 119.

In this manner, a field-effect transistor can be manufactured using the single crystal semiconductor layer 102 that is bonded to the base substrate 100. Because the single crystal semiconductor layer 102 formed according to this embodiment mode is a single crystal semiconductor with uniform crystal orientation, a homogeneous, high-performance field-effect transistor can be obtained. In other words, it is possible to suppress inhomogeneity of values of important transistor characteristics, such as threshold voltage and mobility, and to achieve high performance such as high mobility.

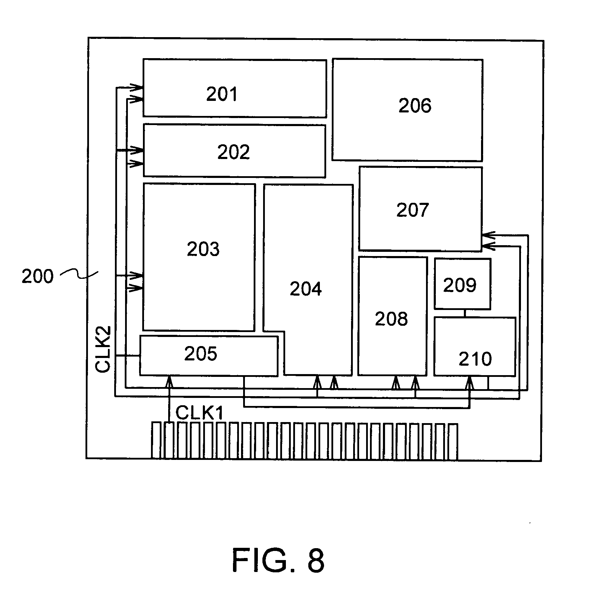

FIG 8 shows an example of a microprocessor 200 as an example of a semiconductor device. The microprocessor 200 is manufactured using the semiconductor substrate formed by any methods described in Embodiment Modes 2 to 4 as described above. The microprocessor 200 has an arithmetic logic unit (ALU) 201, an ALU controller 202, an instruction decoder 203, an interrupt controller 204, a timing controller 205, a register 206, a register controller 207, a bus interface (Bus I/F) 208, a read-only memory 209, and a ROM interface (ROM I/F) 210.

An instruction input to the microprocessor 200 through the bus interface 208 is input to the instruction decoder 203, decoded therein, and then input to the ALU controller 202, the interrupt controller 204, the register controller 207, and the timing controller 205. The ALU controller 202, the interrupt controller 204, the register controller 207, and the timing controller 205 conduct various controls based on the decoded instruction. Specifically, the ALU controller 202 generates signals for controlling the operation of the ALU 201. While the microprocessor 200 is executing a program, the interrupt controller 204 processes an interrupt request from an external input/output device or a peripheral circuit based on its priority or a mask state. The register controller 207 generates an address of the register 206, and reads and writes data from and to the register 206 in accordance with the state of the microprocessor 200. The timing controller 205 generates signals for controlling timing of operation of the ALU 201, the ALU controller 202, the instruction decoder 203, the interrupt controller 204, and the register controller 207. For example, the timing controller 205 is provided with an internal clock generator for generating an internal clock signal CLK2 based on a reference clock signal CLK1, and supplies the clock signal CLK2 to the various above-mentioned circuits. Obviously, the microprocessor 200 shown in FIG. 8 is only an example in which the configuration is simplified, and an actual microprocessor may have various configurations depending on the uses.

The microprocessor 200 in this embodiment mode can achieve not only an increase in processing speed but also a reduction in power consumption because an integrated circuit is formed using a single crystal semiconductor layer with uniform crystal orientation which is bonded over a substrate having an insulating surface or an insulating substrate.

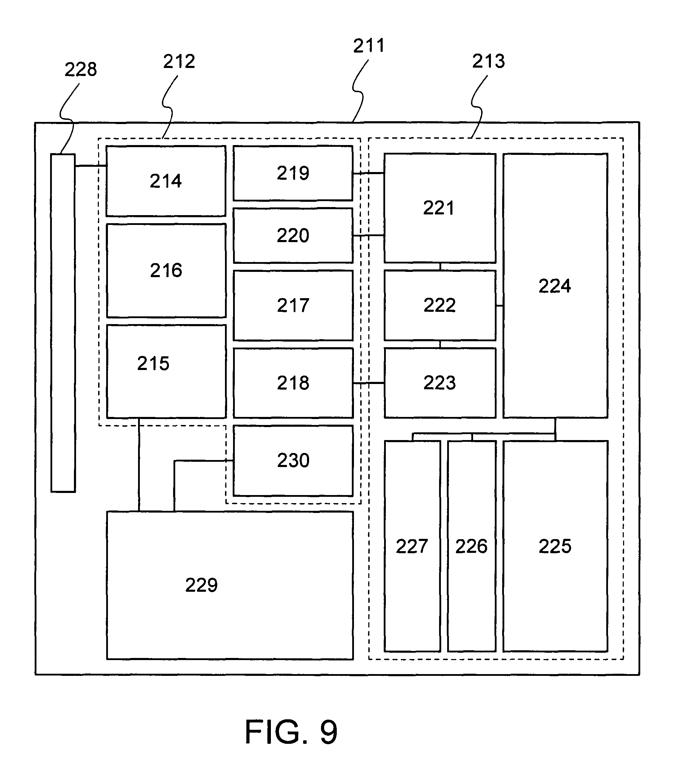

Next, an example of a semiconductor device having an arithmetic function that enables contactless data transmission and reception is described with reference to FIG 9. FIG. 9 shows an example of a computer that operates to transmit and receive signals to and from an external device by wireless communication (such a computer is hereinafter referred to as an RFCPU). An RFCPU 211 has an analog circuit portion 212 and a digital circuit portion 213. The analog circuit portion 212 has a resonance circuit 214 with a resonance capacitor, a rectifier circuit 215, a constant voltage circuit 216, a reset circuit 217, an oscillator circuit 218, a demodulator circuit 219, a modulator circuit 220, and a power management circuit 230. The digital circuit portion 213 has an RF interface 221, a control register 222, a clock controller 223, a CPU interface 224, a central processing unit 225, a random-access memory 226, and a read-only memory 227.

The operation of the RFCPU 211 having such a configuration is as follows. The resonance circuit 214 generates an induced electromotive force based on a signal received by an antenna 228. The induced electromotive force is stored in a capacitor portion 229 through the rectifier circuit 215. This capacitor portion 229 is preferably formed using a capacitor such as a ceramic capacitor or an electric double layer capacitor. The capacitor portion 229 does not need to be integrated with the RFCPU 211 and it is acceptable as long as the capacitor portion 229 is mounted as a different component on a substrate having an insulating surface which is included in the RFCPU 211.

The reset circuit 217 generates a signal for resetting and initializing the digital circuit portion 213. For example, the reset circuit 217 generates a signal which rises after rise in the power supply voltage with delay as a reset signal. The oscillator circuit 218 changes the frequency and duty ratio of a clock signal in response to a control signal generated by the constant voltage circuit 216. The demodulator circuit 219 formed using a low-pass filter binarizes the amplitude of, for example, a received amplitude-modulated (ASK) signal. The modulator circuit 220 varies the amplitude of an amplitude-modulated (ASK) transmission signal and transmits the data. The modulator circuit 220 changes the amplitude of a communication signal by changing a resonance point of the resonance circuit 214. The clock controller 223 generates a control signal for changing the frequency and duty ratio of a clock signal in accordance with the power supply voltage or a consumption current of the central processing unit 225. The power supply voltage is managed by the power management circuit 230.

A signal input from the antenna 228 to the RFCPU 211 is demodulated by the demodulator circuit 219 and then decomposed into a control command, data, and the like by the RF interface 221. The control command is stored in the control register 222. The control command includes reading of data stored in the read-only memory 227, writing of data to the random-access memory 226, an arithmetic instruction to the central processing unit 225, and the like. The central processing unit 225 accesses the read-only memory 227, the random-access memory 226, and the control register 222 via the CPU interface 224. The CPU interface 224 has a function of generating an access signal for any of the read-only memory 227, the random-access memory 226, and the control register 222 based on an address the central processing unit 225 requests.

As an arithmetic method of the central processing unit 225, a method may be employed in which the read-only memory 227 stores an operating system (OS) and a program is read and executed at the time of starting operation. Alternatively, a method may be employed in which a dedicated arithmetic circuit is provided and arithmetic processing is conducted using hardware. In a method in which both hardware and software are used, part of processing is conducted by a dedicated arithmetic circuit and the other part of the arithmetic processing is conducted by the central processing unit 225 using a program.

The RFCPU 211 described in this embodiment mode can achieve not only an increase in processing speed but also a reduction in power consumption because an integrated circuit is formed using a single crystal semiconductor layer with uniform crystal orientation which is bonded over a substrate having an insulating surface or an insulating substrate. This makes it possible to ensure the operation for a long period of time even when the capacitor portion 229 which supplies power is downsized.

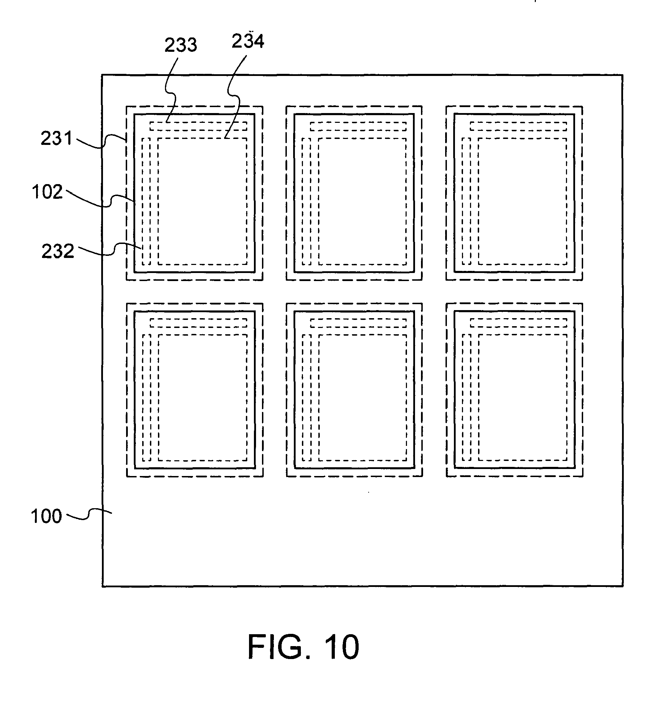

The single crystal semiconductor layer 102 exemplified in FIGS. 1A to 2B can be bonded to a large glass substrate called mother glass for manufacturing a display panel. FIG. 10 shows the case where the single crystal semiconductor layer 102 is bonded to mother glass as the base substrate 100. A plurality of display panels is taken from mother glass, and the single crystal semiconductor layer 102 is preferably bonded to match a formation region of a display panel 231. Since a mother glass substrate has a larger area than a semiconductor substrate, the single crystal semiconductor layer 102 is preferably arranged by being divided as shown in FIG. 10. The display panel 231 includes a scanning line driver circuit region 232, a signal line driver circuit region 233, and a pixel formation region 234. The single crystal semiconductor layer 102 is bonded to the base substrate 100 (mother glass) so that these regions are included.

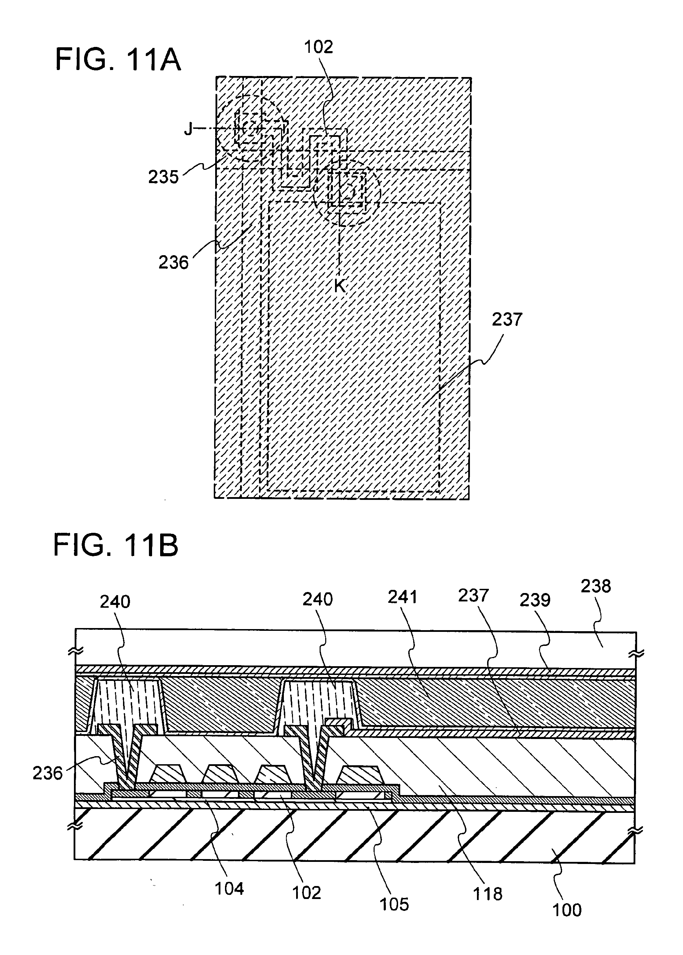

FIGS. 11A and 11B shows an example of a pixel of a display panel in which a pixel transistor is formed using the single crystal semiconductor layer 102. FIG. 11A is a plan view of a pixel, in which a gate wiring 235 intersects with the single crystal semiconductor layer 102 and the single crystal semiconductor layer 102 is connected to a source wiring 236 and a pixel electrode 237. FIG. 11B is a cross-sectional view corresponding to a line J-K in FIG 11A.

In FIG 11B, a stack of a silicon nitride layer and a silicon oxide layer is formed as the barrier layer 105 over the base substrate 100. The single crystal semiconductor layer 102 is fixed to the barrier layer 105 with the use of the bonding layer 104. The pixel electrode 237 is provided over an insulating layer 118. By etching of the insulating layer 118, a step in the form of a depression is generated in a contact hole, in which the single crystal semiconductor layer 102 and the source wiring 236 are connected to each other, and thus, a columnar spacer 240 is provided so as to fill the step. A counter substrate 238 is provided with a counter electrode 239. A liquid layer 241 is formed in a space formed by the columnar spacer 240.

As described above, a single crystal semiconductor layer can be formed and a transistor can be formed also over mother glass for manufacturing a display panel. A transistor formed using a single crystal semiconductor layer is superior to an amorphous silicon transistor in all operating characteristics such as capacity of current drive; therefore, the transistor can be downsized. Accordingly, an aperture ratio of a pixel portion in the display panel can be improved. Further, since a microprocessor like the one illustrated in FIGS. 8 and 9 can be formed, a function as a computer can be provided in the display panel. Furthermore, a display in which data can be input and output without contact can be manufactured.
This application is based on Japanese Patent Applications serial no. 2007-101181 filed with Japan Patent Office on April 6, 2007 and serial no. 2007-109943 filed with Japan Patent Office on April 19, 2007, the entire contents of which are hereby incorporated by reference.

## Claims

1. A method for manufacturing a semiconductor substrate comprising the steps of:
irradiating a single crystal semiconductor substrate with ions of a halogen atom, which had been subjected to mass separation, to form an embrittlement layer in the single crystal semiconductor substrate;
forming a silicon oxide film over the single crystal semiconductor substrate with the use of an organic silane gas by a chemical vapor deposition method;
bonding the single crystal semiconductor substrate and a substrate having an insulating surface with the silicon oxide film interposed therebetween;
performing a thermal treatment in a state where the single crystal semiconductor substrate and the substrate having the insulating surface are superposed on each other; and
separating the single crystal semiconductor substrate with a single crystal semiconductor layer left over the substrate having the insulating surface.

2. The method for manufacturing a semiconductor substrate according to claim 1, wherein the embrittlement layer is formed in a region at a predetermined depth from a surface of the single semiconductor substrate.

3. The method for manufacturing a semiconductor substrate according to claim 1, wherein the halogen atom is one of fluorine, chlorine, bromine, iodine and astatine.

4. The method for manufacturing a semiconductor substrate according to claim 1, further comprising a step of irradiating the single crystal semiconductor substrate with H₃⁺ ions which are obtained by subjecting hydrogen ions to mass separation after the single crystal semiconductor substrate is irradiated with the ions of the halogen atom.

5. The method for manufacturing a semiconductor substrate according to claim 1, further comprising a step of forming an insulating layer containing nitrogen over a surface of the single crystal semiconductor substrate before the single crystal semiconductor substrate is irradiated with the ions of the halogen atom.

6. The method for manufacturing a semiconductor substrate according to claim 1, further comprising a step of forming an insulating layer containing nitrogen over a surface of the single crystal semiconductor substrate before the single crystal semiconductor substrate is irradiated with the ions of the halogen atom,
wherein the insulating layer containing nitrogen includes at least one of a silicon nitride film, a silicon nitride oxide film, and a silicon oxynitride film.

7. The method for manufacturing a semiconductor substrate according to claim 1, wherein the organic silane gas includes one selected from the group consisting of tetraethoxysilane, trimethylsilane, tetramethylcyclotetrasiloxane, octamethylcyclotetrasiloxane, hexamethyldisilazane, triethoxysilane, and trisdimethylaminosilane.

8. The method for manufacturing a semiconductor substrate according to claim 1, wherein the silicon oxide film is formed at a temperature that the halogen atom included in the embrittlement layer does not leave, and wherein the thermal treatment is performed at a temperature that the halogen atom included in the embrittlement layer leaves.

9. The method for manufacturing a semiconductor substrate according to claim 1, wherein the silicon oxide film is formed at 350°C or lower, and wherein the thermal treatment is performed at 400 to 600°C.

10. A method for manufacturing a semiconductor substrate comprising the steps of:
irradiating a single crystal semiconductor substrate with ions of an inert atom, to form an embrittlement layer in the single crystal semiconductor substrate;
forming a silicon oxide film over the single crystal semiconductor substrate with the use of an organic silane gas by a chemical vapor deposition method;
bonding the single crystal semiconductor substrate and a substrate having an insulating surface with the silicon oxide film interposed therebetween;
performing a thermal treatment in a state where the single crystal semiconductor substrate and the substrate having the insulating surface are superposed on each other; and
separating the single crystal semiconductor substrate with a single crystal semiconductor layer left over the substrate having the insulating surface.

11. The method for manufacturing a semiconductor substrate according to claim 10, wherein the embrittlement layer is formed in a region at a predetermined depth from a surface of the single semiconductor substrate.

12. The method for manufacturing a semiconductor substrate according to claim 10, wherein the inert atom is one of helium, neon, argon, krypton and xenon.

13. The method for manufacturing a semiconductor substrate according to claim 10, further comprising a step of irradiating the single crystal semiconductor substrate with H₃⁺ ions which are obtained by subjecting hydrogen ions to mass separation after the single crystal semiconductor substrate is irradiated with the ions of the inert atom

14. The method for manufacturing a semiconductor substrate according to claim 10, further comprising a step of forming an insulating layer containing nitrogen over a surface of the single crystal semiconductor substrate before the single crystal semiconductor substrate is irradiated with the ions of the inert atom

15. The method for manufacturing a semiconductor substrate according to claim 10, further comprising a step of forming an insulating layer containing nitrogen over a surface of the single crystal semiconductor substrate before the single crystal semiconductor substrate is irradiated with the ions of the inert atom, wherein the insulating layer containing nitrogen includes at least one of a silicon nitride film, a silicon nitride oxide film, and a silicon oxynitride film.

16. The method for manufacturing a semiconductor substrate according to claim 10, wherein the organic silane gas includes one selected from the group consisting of tetraethoxysilane, trimethylsilane, tetramethylcyclotetrasiloxane, octamethylcyclotetrasiloxane, hexamethyldisilazane, triethoxysi lane, and trisdimethylaminosi lane.

17. The method for manufacturing a semiconductor substrate according to claim 10, wherein the silicon oxide film is formed at a temperature that the inert atom included in the embrittlement layer does not leave, and wherein the thermal treatment is performed at a temperature that the inert atom included in the embrittlement layer leaves.

18. The method for manufacturing a semiconductor substrate according to claim 10, wherein the silicon oxide film is formed at 350°C or lower, and wherein the thermal treatment is performed at 400 to 600°C.

19. A method for manufacturing a semiconductor substrate comprising the steps of:
irradiating a single crystal semiconductor substrate with H₃⁺ ions, which are obtained by subjecting hydrogen ions to mass separation, to form an embrittlement layer in the single crystal semiconductor substrate;
forming a silicon oxide film over the single crystal semiconductor substrate with the use of an organic silane gas by a chemical vapor deposition method;
bonding the single crystal semiconductor substrate and a substrate having an insulating surface with the silicon oxide film interposed therebetween;
performing a thermal treatment in a state where the single crystal semiconductor substrate and the substrate having the insulating surface are superposed on each other; and
separating the single crystal semiconductor substrate with a single crystal semiconductor layer left over the substrate having the insulating surface.

20. The method for manufacturing a semiconductor substrate according to claim 19, wherein the embrittlement layer is formed in a region at a predetermined depth from a surface of the single semiconductor substrate.

21. The method for manufacturing a semiconductor substrate according to claim 19, further comprising a step of forming an insulating layer containing nitrogen over a surface of the single crystal semiconductor substrate before the single crystal semiconductor substrate is irradiated with the H₃⁺ ions.

22. The method for manufacturing a semiconductor substrate according to claim 19, further comprising a step of forming an insulating layer containing nitrogen over a surface of the single crystal semiconductor substrate before the single crystal semiconductor substrate is irradiated with the H₃⁺ ions, wherein the insulating layer containing nitrogen includes at least one of a silicon nitride film, a silicon nitride oxide film, and a silicon oxynitride film.

23. The method for manufacturing a semiconductor substrate according to claim 19, wherein the organic silane gas includes one selected from the group consisting of tetraethoxysilane, trimethylsilane, tetramethylcyclotetrasiloxane, octamethylcyclotetrasiloxane, hexamethyldisilazane, triethoxysilane, and trisdimethylaminosilane.

24. The method for manufacturing a semiconductor substrate according to claim 19, wherein the silicon oxide film is formed at a temperature that a hydrogen atom included in the embrittlement layer does not leave, and wherein the thermal treatment is performed at a temperature that the hydrogen atom included in the embrittlement layer leaves.

25. The method for manufacturing a semiconductor substrate according to claim 19, wherein the silicon oxide film is formed at 350°C or lower, and wherein the thermal treatment is performed at 400 to 600°C.
